# EUROPEAN PATENT APPLICATION

(11) **EP 1 646 122 A1**
(43) Date of publication of application: **12.04.2006**
(21) Application number: 04256176.1
(22) Date of filing: 06.10.2004
(51) Int. Cl.: H02J 7/00, H02K 1/16

(54) **Multilayer printed circuit board comprising a battery charging circuitry and an induction coil**

(71) Applicant: Nokia Corporation, 02150 Espoo (FI)
(72) Inventor: Paanenen, Heikki, Tokyo (JP)
(74) Representative: Slingsby, Philip Roy

(57) **Abstract**

A circuit board for an electrical device, the circuit board having: at least one coil for receiving a magnetic field from a source remote from the circuit board and generating an alternating electrical field therefrom, the coil being defined by conductive tracks lying on or in the circuit board; and a charging circuit having an input and an output, the input being connected to the coil and the charging circuit being arranged for providing a direct current at the output from the said electrical field generated by the coil.

## Description

This invention relates to charging circuitry, for example circuitry suitable for allowing portable devices such as mobile phones to be charged with energy.

Many portable devices are powered by rechargeable electrical energy sources such as batteries and fuel cells. Examples include mobile phones, cameras, PDAs (personal digital assistants) and torches. One method for charging the batteries of such devices is inductive charging. Inductive charging systems are described in, for example EP 0 817 351, US 5,600,225 and US 6,184,651. The reader is referred to those documents for a description of the principles of inductive charging. In inductive charging, a portable device is equipped with a coil that can be energised inductively by a coil in a nearby charging unit. Energy can thus be conveyed from the charging unit to the portable device, and can be used to charge a battery of or otherwise power the portable device.

One particular arrangement for inductive charging is described in US 2003/0003971. US 2003/0003971 discloses an arrangement in which a rechargeable device is has an opening that is surrounded by a secondary charging coil. The opening can receive the primary coil of a charging device. This arrangement is advantageous since it can allow a user to conveniently attach the device to be charged to the charging device, it can naturally align the primary secondary coils so as to allow efficient energy transfer between them, and it can allow multiple devices to be charged on the same primary coil.

One way to implement a device that can be charged as described in US 2003/0003971 is to use a discrete coil component that surrounds the opening and forms the secondary charging coil. A coil of copper wire can be used since the magnetic flux may be low. This arrangement is convenient in that it allows the device to be implemented in a way that requires little alteration to existing devices: the coil can be attached so as to extend from a conventional circuit board. However, it suffers from a number of problems.

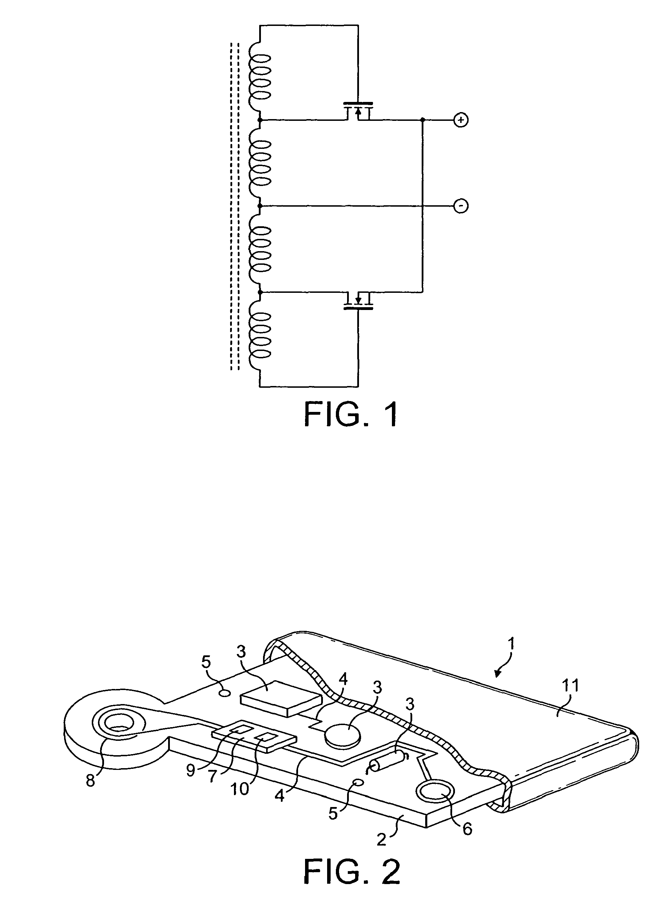

First, when a single coil is present the charging circuit is typically a rectifying diode bridge with its inputs connected across the coil and a smoothing capacitor connected across its outputs. This circuit is simple but undesirable because the diodes of the bridge heat up during use, wasting power and requiring the designer to take measures to dissipate the heat. A more preferred charging circuit is illustrated in figure 1. In this circuit a more complex coil is used, but it allows a synchronous FET (field effect transistor) rectifier to be used. Since such FETs can have a low on-resistance the losses in this circuit can be negligible and little heat can be generated. However, this requires a more complex arrangement of coil windings, which makes the coil a costly component.

Second, the use of a discrete coil component makes it difficult to minimize the size of the device.

There is therefore a need for an improved arrangement for charging circuitry.

Separately from the field of battery charging, in switched mode power supplies it is known to define primary and secondary windings of a transformer as tracks on a PWB. This configuration is advantageous in that context because the primary and secondary coils are not intended to be separated. Thus their mutual locations can readily be fixed by defining them both on a PWB.

According to the present invention there is provided a circuit board for an electrical device, the circuit board having: at least one coil for receiving a magnetic field from a source remote from the circuit board and generating an alternating electrical field therefrom, the coil being defined by conductive tracks lying on or in the circuit board; and a charging circuit having an input and an output, the input being connected to the coil and the charging circuit being arranged for providing a direct current at the output from the said electrical field generated by the coil.

Preferably the charging circuit comprises a rectifying circuit for receiving an alternating current input from the coil and forming a direct current output therefrom.

Preferably the charging circuit comprises capacitative means for smoothing the direct current output.

Preferably the circuit board comprises a rechargeable electrical energy store connected so as to receive the said direct current for recharging thereof.

Preferably the coil comprises two or more spiral structures defined by conductive tracks on the circuit board.

Preferably the spiral structures are interpenetrating and non-overlapping.

Preferably the circuit board comprises two or more layers of conductive tracks separated by at least one layer of non-conductive material and the coil comprises at least one structure in each of at least two of the said layers of conductive tracks.

Preferably the rectifier is connected to the coil at three or more electrically distinct points.

Preferably the rectifier is connected to the coil at four or more electrically distinct points.

Preferably the rectifying circuit comprises a pair of rectifying transistors coupled to the coil so as to form the said direct current output.

Preferably the circuit board has at least one coil for receiving a magnetic field, the coil being defined by conductive tracks on or in the circuit board, and the circuit board defining a hole located internally of the coil and extending through the circuit board

The present invention will now be described by way of example with reference to the accompanying drawings, in which:
figure 1 shows a prior art charging circuit employing a synchronous FET rectifier;
figure 2 is a cut-away view of a portable device;
figure 3 shows examples of the physical configuration of a circuit board and coil;
figure 4 shows examples of the configuration of separate sub-coils;
figure 5 shows examples of charging circuits;

Figure 2 shows a cut-away view of a portable device 1. The device comprises a printed wiring board (PWB) 2 which carries discrete components 3 such as integrated circuits, resistors and capacitors. Components on the board 2 are interconnected by wiring tracks 4 in and on the PWB, often at different levels within the PWB, and vias 5 running between levels of the PWB. The interconnected components provide at least some of the functionality of the device. The device has a rechargeable battery 6 which can power the device, and charging circuitry 7 for supplying energy to the battery to allow it to be recharged. The charging circuitry is connected to a coil 8 and includes a rectifier 9 and a smoothing capacitor 10. The coil is implemented by means of tracks in or on the PWB 2. This design allows the coil to be implemented in a particularly efficient manner. There is no need for a discrete coil component, which avoids the cost of that component and of attaching it to the PWB. Since technology is readily available to define complex wiring patterns on PWBs, this technique also allows complex coil patterns, that allow efficient coupling to a primary coil and enable efficient charging circuits to be used, to be readily constructed.

The device has an outer case 11 that encloses the PWB 2.

In operation, the coil 8 can be energised by an alternating magnetic field, e.g. from another coil of a nearby device. That field induces an alternating electrical field in the coil which can be rectified by the rectifier 9 and smoothed by the capacitative means 10 so as to power the operation and/or charging of the device.

Some examples of how the coil may be formed on the PWB will now be described in more detail.

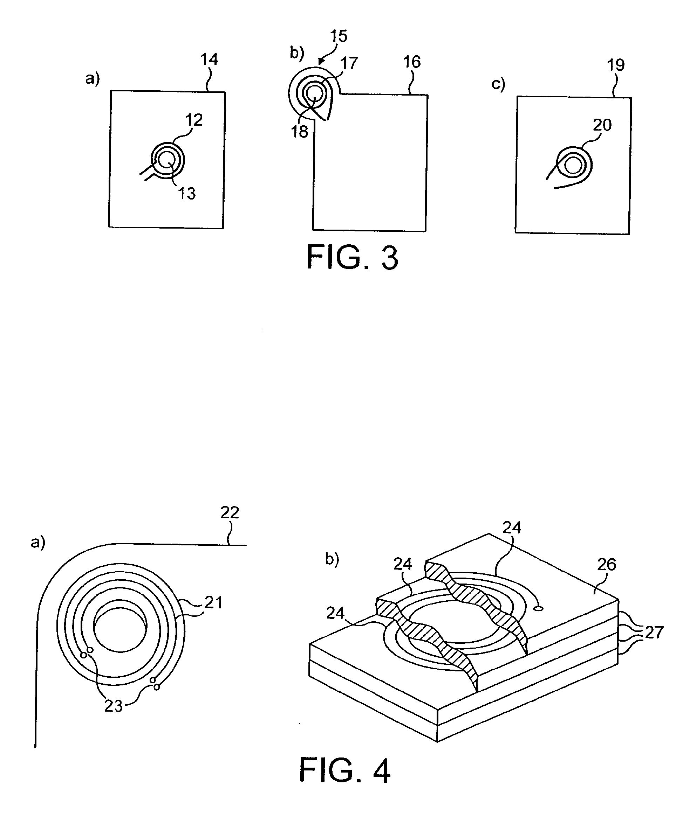

Figure 3 shows examples of the physical configuration of a circuit board and coil. In the example of figure 3a, a coil 12 is formed around a hole 13 in the body of PWB 14. In the example of figure 3b, an arch 15 protrudes from the body of the PWB 16 and the coil 17 is located around the hole 18 between the arch and the body of the PWB. In each of these examples the coil is formed around a hole that extends through the body of PWB. This allows a device into which the PWB is incorporated to be charged by a charging coil or core inserted into the hole. Examples of this method are described in US 2003/0003971. This method can allow a user to easily attain good coupling between the charger and the coil of the charged device. In the example of figure 3c the PWB 19 is intact internally of the coil 20 and so there is no hole on the PWB internally of the coil. This coil can be charged by being brought into proximity with a charging coil.

The coil may comprise a number of separate sub-coils, either as separate structures, or by taking taps off a single coil structure. These sub-coils are useful in that they can permit more complex charging circuits to be used. One way to form separate sub-coils, as illustrated in figure 4a, is to define two or more interpenetrating and non-overlapping spirals of conductive material 21 at a single level of a PWB 22. Each spiral can act as a sub-coil. Connections to charging circuitry can be made from each end 23 of each sub-coil. Another way to form separate sub-coils, as illustrated in the cut-away view of figure 4b, is to define each sub-coil 24 in a different level of a PWB 26. Each level of the PWB has a pattern of conductive material from which conductive tracks including the sub-coils can be defined. These are separated by a layer of insulating material 27 between each level and the next. The conductive material of separate layers can be connected by conductive material in a via hole running between the layers. Either of these techniques allows multiple sub-coils to be formed in a single area of the PWB and connected in parallel or in series to charging circuitry. These techniques may be used in combination.

The number of windings of each coil or sub-coil and the shape of each winding may be selected to optimize charging characteristics. A single coil or sub-coil may be formed by interconnecting windings on one or more levels of the PWB so as to increase the total number of windings that the coil or sub-coil has.

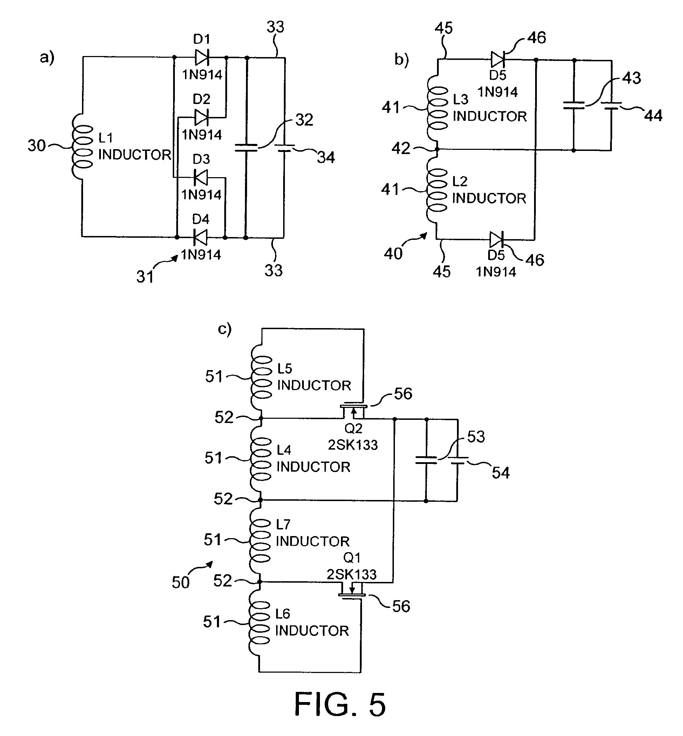

Figure 5 shows examples of charging circuits that could be used with coils as described herein. In the charging circuit of figure 5a, a coil 30 having a tap at each of its ends is connected to a rectifying network of diodes 31. The outputs of the rectifying network are connected across a capacitor 32, and to the terminals 33 of a battery 34 for charging. In the charging circuit of figure 5b, a coil 40 is formed of two sub-coils 41, which could be separate structures from each other connected at a central tap point 42 or could be formed by taking a central tap from a single coil structure. The central tap 42 is connected to one terminal of capacitor 43 and to one terminal of battery 44. Connections 45 to the other ends of the coil or sub-coils are connected via rectifying diodes 46 to the other terminals of the capacitor and the battery. In the Charging circuit of figure 5c, a coil 50 is formed of four sub-coils 51, which could be separate structures from each other but connected in series at tap points 52 or could be formed by taking a three central taps from a single coil structure. The centre-most of the taps 52 is connected to one terminal of capacitor 53 and to one terminal of battery 54. Each end-point of the coil 50 is connected to the gate of a respective rectifying FET 56. Each of the remaining taps 52 is connected to the source of one of the rectifying FETs. The drains of the rectifying FETs are connected to the other terminals of the capacitor and the battery. Other charging circuits, which may be similar or dissimilar to those of figure 5, may be used.

A device in which the coil is used may include more than one PWB. The charging circuitry is preferably but not necessarily formed on the same PWB as that which carries the coil. The battery can be connected to the PWB by spring connectors or other means.

Each coil or sub-coil can be formed by the same technique as is used to form other conductive layers in or on the PWB. This may, for example, be by selective deposition of conductive material (e.g. a metal such as copper) on regions of the PWB or by selective removal of conductive material (e.g. by etching) from regions of the PWB.

The board on which the or each coil is defined may be any form of wiring or circuit board. The board is preferably rigid, but may alternatively be flexible. The conductive patterning may be printed on the board. The board may have one, two or more layers of conductive patterning.

A hole through the coil, if required, can be formed by stamping or drilling of the wiring board.

The device is preferably sized and configured so as to be portable. The battery (which could be replaced or supplemented by another electrically rechargeable energy source such as a capacitor) is preferably capable of storing energy suitable for powering the device for a prolonged period, preferably more than a week, and more preferably more than a month. Instead of or in addition to having its battery charged by means of the coil, the device may be powered from the coil: possibly but not exclusively when the battery is being charged.

In the manufacture of the device, the board including the conductive material defining the or each coil can be formed first. Then components can be attached to the board. Finally the board can be encased in an outer cover for protection.

The device could be any electrically operated device, preferably a portable device. Non-limiting examples include mobile phones, PDAs, laptop computers, torches, personal music players, watches and televisions.

US 2003/0003971, to which the reader is referred, describes further principles and options for inductive charging.

The applicant hereby discloses in isolation each individual feature described herein and any combination of two or more such features, to the extent that such features or combinations are capable of being carried out based on the present specification as a whole in the light of the common general knowledge of a person skilled in the art, irrespective of whether such features or combinations of features solve any problems disclosed herein, and without limitation to the scope of the claims. The applicant indicates that aspects of the present invention may consist of any such individual feature or combination of features. In view of the foregoing description it will be evident to a person skilled in the art that various modifications may be made within the scope of the invention.

## Claims

1. A circuit board for an electrical device, the circuit board having:
at least one coil for receiving a magnetic field from a source remote from the circuit board and generating an alternating electrical field therefrom, the coil being defined by conductive tracks lying on or in the circuit board; and
a charging circuit having an input and an output, the input being connected to the coil and the charging circuit being arranged for providing a direct current at the output from the said electrical field generated by the coil.

2. A circuit board as claimed in claim 1, wherein the charging circuit comprises a rectifying circuit for receiving an alternating current input from the coil and forming a direct current output therefrom.

3. A circuit board as claimed in claim 2, wherein the charging circuit comprises capacitative means for smoothing the direct current output.

4. A circuit board as claimed in any preceding claim, comprising a rechargeable electrical energy store connected so as to receive the said direct current for recharging thereof.

5. A circuit board as claimed in any preceding claim, wherein the coil comprises two or more spiral structures defined by conductive tracks on the circuit board.

6. A circuit board as claimed in claim 5, wherein the spiral structures are interpenetrating and non-overlapping.

7. A circuit board as claimed in any preceding claim, wherein the circuit board comprises two or more layers of conductive tracks separated by at least one layer of non-conductive material and the coil comprises at least one structure in each of at least two of the said layers of conductive tracks.

8. A circuit board as claimed in any preceding claim, wherein the rectifier is connected to the coil at three or more electrically distinct points.

9. A circuit board as claimed in any preceding claim, wherein the rectifier is connected to the coil at four or more electrically distinct points.

10. A circuit board as claimed in claim 9 as dependent on claim 2, wherein the rectifying circuit comprises a pair of rectifying transistors coupled to the coil so as to form the said direct current output.

11. A circuit board for an electrical device, the circuit board having at least one coil for receiving a magnetic field, the coil being defined by conductive tracks on or in the circuit board, and the circuit board defining a hole located internally of the coil and extending through the circuit board

12. An electrical device comprising a circuit board as claimed in any preceding claim.

13. An electrical device as claimed in claim 12, wherein the device is a mobile phone.
